**Europäisches Patentamt**

**European Patent Office**

**Office européen des brevets**

(19)

(11) Veröffentlichungsnummer: **0 065 063**
A1

# EUROPÄISCHE PATENTANMELDUNG

(12)

(21) Anmeldenummer: **82100235.9**

(51) Int. Cl.³: **H 03 F 1/52**

(22) Anmeldetag: **14.01.82**

(30) Priorität: **15.05.81 DE 3119328**

(43) Veröffentlichungstag der Anmeldung: **24.11.82**
**Patentblatt 82/47**

(84) Benannte Vertragsstaaten: **DE FR GB**

(71) Anmelder: **ROBERT BOSCH GMBH, Postfach 50, D-7000 Stuttgart 1 (DE)**

(72) Erfinder: **Sigel, Horst, Dipl.-Ing., Pfarrstrasse 2, D-7066 Hohengehren (DE)**

(54) **Vorrichtung zur Strombegrenzung einer Gegentaktendstufe.**

(57) Vorrichtung zur Strombegrenzung einer Gegentaktendstufe, bei der durch äußere Einflüsse eine Zerstörung der Gegentaktendstufe nicht möglich ist. In jeden Kollektorzweig der Gegentaktendstufe ist ein als Strombegrenzer geschalteter integrierter Spannungsstabilisator (4, 6) geschaltet. Dadurch können die Endstufentransistoren (2, 3) weder durch eine extern am Ausgang angelegte Spannung noch durch einen Kurzschluß zerstört werden.

EP 0 065 063 A1

R.    6987

Fd/Jä 13.5.1981

Robert Bosch GmbH, 7000 Stuttgart 1

## Vorrichtung zur Strombegrenzung einer Gegentaktendstufe

Stand der Technik

Die Erfindung geht aus von einer Vorrichtung zur Strombegrenzung nach der Gattung des Hauptanspruchs. Aus National Semiconductors, Linear Databook, 1980, Seite 1/21 ist bereits eine Verstärkervorrichtung bekannt, bei der im Kollektorkreis eines Verstärkers ein als Strombegrenzer geschalteter Spannungsregler vorgesehen ist. Das Ausgangssignal wird bei dieser bekannten Vorrichtung zwischen dem Spannungsregler und dem Kollektor des Transistors abgegriffen. Die bekannte Anordnung hat den Nachteil, daß der Transistor durch eine externe Spannung, die an den Ausgang angelegt wird, durch Überlastung zerstört wird, da keine Strombegrenzung erfolgt.

Vorteile der Erfindung

Die erfindungsgemäße Vorrichtung mit den kennzeichnenden Merkmalen des Hauptanspruchs hat demgegenüber den Vorteil, daß der Ausgangsstrom der Vorrichtung in beiden Richtungen auf exakt einstellbare Werte begrenzt wird. Als weiterer Vorteil ist anzusehen, daß

...

- 2 -

die Ausgangstransistoren nicht durch eine externe Spannung oder durch einen Kurzschluß zerstört werden können.

Durch die im Unteranspruch aufgeführte Maßnahme ist
eine vorteilhafte Weiterbildung und Verbesserung der
im Hauptanspruch angegebenen Vorrichtung möglich.
Durch geeignete Wahl der den Strom bestimmenden Widerstände ist der Strom, der über die Transistoren fließen
kann, in beiden Richtungen verschieden einstellbar.

Zeichnung

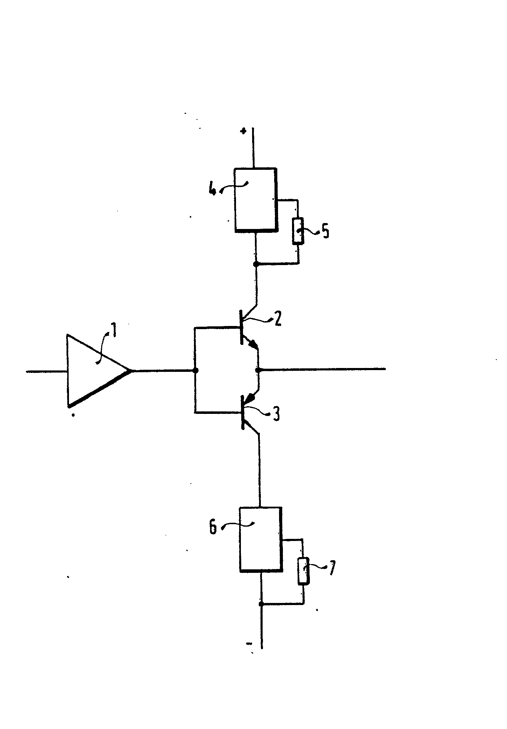

Ein Ausführungsbeispiel der Erfindung ist in der Zeichnung dargestellt und in der nachfolgenden Beschreibung
näher erläutert.

Beschreibung des Ausführungsbeispiels

Die Figur zeigt einen Vorverstärker 1, an dessen Ausgang
die Basen der beiden Transistoren 2 und 3 angeschlossen
sind. Die Emitter der beiden Transistoren 2 und 3 sind
miteinander verbunden. An einer Ausgangsleitung, die
an die Emitter angeschlossen ist, ist das verstärkte
Signal abgreifbar. An den Kollektor des Transistors 2
ist ein als Strombegrenzer geschalteter integrierter
Spannungsregler 4 angeschlossen, der seinerseits mit
der positiven Versorgungsspannung in Verbindung steht.
An den integrierten Spannungsregler 4 ist ein Widerstand 5 angeschlossen, mit dem die Strombegrenzung einstellbar ist. Ebenso ist an den Kollektor des Transistors 3 ein als Strombegrenzer geschalteter integrierter Spannungsregler 6 angeschlossen, dessen weiterer Eingang mit der negativen Versorgungsspannung verbunden ist. Ein Widerstand 7, der einerseits an die negative Versorgungsspannung und andererseits an den integrierten Spannungsregler 6 angeschlossen ist, ermöglicht das Einstellen der Strombegrenzung. Für die integrierten Spannungsregler 4 und 6 sind beliebige positive Spannungsregler geeignet. Ihre Wahl ist im wesentlichen durch den maximal zulässigen Strom bedingt. Geeignet ist beispielsweise der Typ LM 117 der Firma National Semiconductors. Tritt nun am Ausgang der Gegentaktendstufe ein Kurzschluß auf, so wird der Strom durch den Transistor 2 oder 3 entweder durch den Strombe- grenzer 4 oder durch den Strombegrenzer 6 beschränkt, so daß weder der Transistor 2 noch der Transistor 3 beschädigt werden kann. Tritt am Ausgang eine externe Spannung auf, so sorgen ebenfalls die als Strombegrenzer geschalteten Spannungsregler 4 und 6 dafür, daß der Strom durch die Transistoren 2 und 3 nicht unzulässig ansteigen kann. Eine Zerstörung der Transistoren 2 und 3 kann also nicht erfolgen, wenn nicht die maximal zulässige Basis-Emitter-Sperrspannung überschritten wird.

R. 6087
Fd/Jä 13.5.1981

Robert Bosch GmbH, 7000 Stuttgart 1

Ansprüche

1. Vorrichtung zur Strombegrenzung einer Endstufe mit einem als Strombegrenzer geschalteten integrierten Spannungsstabilisator, dadurch gekennzeichnet, daß die Endstufe als Gegentaktendstufe mit zwei Transistoren (2, 3) ausgebildet ist, wobei in jedem Kollektorzweig ein als Strombegrenzer geschalteter integrierter Spannungsstabilisator (4, 6) angeordnet ist und an den miteinander verbundenen Emittern die Ausgangsspannung abgreifbar ist.

2. Vorrichtung nach Anspruch 1, dadurch gekennzeichnet, daß der Ausgangsstrom durch je einen Widerstand (5, 7) in beiden Zweigen beliebig einstellbar ist.

Europäisches
Patentamt

**EUROPÄISCHER RECHERCHENBERICHT**

0065063
Nummer der Anmeldung

EP 82 10 0235.9

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 3 486 124 (M.F. EISENBERG) <br> * Fig. 1 * | 1 |
| A | US - A - 4 215 318 (Y KAWANABE) <br> * Fig. 1 * | |
| A | DE - B2 - 2 800 200 (RCA) <br> * Fig. 2 * | |
| A | US - A - 3 508 162 (M.F. EISENBERG) <br> * Fig. 1 * | |

**KLASSIFIKATION DER ANMELDUNG (Int. Cl.³)**

H 03 F 1/52

**RECHERCHIERTE SACHGEBIETE (Int. Cl.³)**

H 03 F 1/52

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 09-08-1982 | BREUSING |

EPA form 1503.1  06.78